# EUROPÄISCHE PATENTSCHRIFT

(11) **EP 0 926 929 B1**
(45) Veröffentlichungstag und Bekanntmachung des Hinweises auf die Patenterteilung: **13.12.2006**
(21) Anmeldenummer: 98118070.6
(22) Anmeldetag: 24.09.1998
(51) Int. Cl.: H05K 1/02, H05K 1/05

(54) **Mehrlagen-Leiterplatte**
Multilayer printed circuit board
Plaque à circuit imprimé multicouche

(30) Priorität: 19.12.1997 DE 19756818
(43) Veröffentlichungstag der Anmeldung: 30.06.1999
(73) Patentinhaber: Tesat-Spacecom GmbH & Co. KG, 71522 Backnang (DE)
(72) Erfinder: Bovensiepen, Kurt, 71364 Winnenden (DE); Ulmer, Helmut, 71522 Backnang (DE); Messarosch, Gerhard, 71409 Schwaikheim (DE)
(74) Vertreter: Schuster, Gregor

(56) Entgegenhaltungen:
- EP-A- 0 393 312
- DE-A- 4 131 717
- US-A- 4 609 586
- US-A- 4 654 248
- US-A- 4 711 804
- US-A- 5 374 788

## Beschreibung

### Stand der Technik

Die Erfindung betrifft eine Mehrlagen-Leiterplatte mit den im Oberbegriff des Anspruchs 1 angegebenen Merkmalen.

Bei der Bestückung von Mehrlagen-Leiterplatten mit elektronischen Bauelementen ist bekannt, Bauelemente ohne Anschlußbeinchen, z.B. sogenannte LCCC-Bauelemente (Leadless Ceramic Chip Carrier), direkt auf entsprechende Anschlußflächen der Mehrlagen-Leiterplatte aufzulöten. Bei Temperaturwechselbelastungen resultieren aus den unterschiedlichen Wärmeausdehnungskoeffizienten von keramischen Chipträgern und Leiterplatte Scherkräfte, welche die Lötstellen des Bauelementes aufnehmen müssen. Bei starken Temperaturschwankungen, wie sie insbesondere in der Raumfahrttechnik beispielsweise bei einem um die Erde kreisenden Satelliten auftreten, würde die unterschiedliche Wärmeausdehnung von großflächigen keramischen Bauelementen und der Leiterplatte zu einer Beschädigung der Lötstellen und zum Ausfall der Baugruppe führen. Bei einem im Weltraum stationierten Satelliten ist ein solcher Lötstellendefekt äußerst verhängnisvoll, da er in der Regel zum Ausfall des betroffenen Gerätes führt. Zur Lösung der bekannten Problematik ist bekannt, Mehrlagen-Leiterplatten mit einem Kernsubstrat zu verwenden.

Aus der US 4,711,804 ist eine Leiterplatte bekannt mit einem inneren Kern aus gut thermischleitendem Material typischerweise aus Kupfer, Aluminium oder anderen Metallen. In dieser Kernschicht sind Öffnungen direkt unterhalb der elektronischen Bauteile vorhanden. In diesen Öffnungen sind Einlagen vorhanden, die einen ähnlichen thermischen Koofizienten besitzen wie das auf der Leiterplatte angeordnete elektronische Bauteil.

Bekannt sind Kernsubstrate aus Metall oder Kohlefaserverbundwerkstoffen. Beispielsweise ist aus der US-A-4 921 054 eine thermomechanisch angepaßte Mehrlagen-Leiterplatte mit zwei das Ausdehnungsverhalten der Leiterplatte steuernden Kernsubstraten aus kupferplattiertem Invar bekannt. Der Schichtverbundwerkstoff aus Kernsubstraten und Leiterplattenmaterial wird durch Stapeln und Verpressen hergestellt, wobei der Ausdehnungskoeffizient der gesamten aus Isolierstoff, Leiterbahnlagen und Kernsubstraten bestehenden Anordnung durch den Anteil des Kernsubstrats an der Gesamtdicke des Schichtverbundes bestimmt wird. Da das Kernsubstrat einen deutlich kleineren thermischen Ausdehnungskoeffizienten als das Leiterplattenmaterial aufweist, welches in der Regel aus einem Epoxid/Glas-Material besteht, kann erreicht werden, daß der resultierende thermische Ausdehnungskoeffizient der mit dem Kern versehenen Mehrlagen-Leiterplatte an den Ausdehnungskoeffizienten der keramischen Bauelemente angepaßt ist. Im Erstreckungsbereich der Bauelemente treten daher keine nachteiligen Scherkräfte auf, welche die Lötstelle beschädigen könnten.

Trotz der Vorteile der bekannten Mehrlagen-Leiterplatten muß als nachteilig angesehen werden, daß die Herstellung der durch das Kernsubstrat geführten Durchkontaktierungen äußerst aufwendig ist. Weiterhin ist nachteilig, daß die über die gesamte Flächenausdehnung der Leiterplatte sich erstreckenden Kernsubstrate das Gewicht der Leiterplatte deutlich erhöhen, was in der Raumfahrttechnik äußerst unerwünscht ist. Nachteilig ist auch, daß mit den bekannten Kernsubstraten die Größe der Mehrlagen-Leiterplatte erhöht wird. Da die Leiterbahnführung nicht in der Ebene des Kernsubstrats erfolgen kann, muß entweder die Dicke der Leiterplatte erhöht oder die Leiterplatte muß seitlich vergrößert werden. Beides ist äußerst unerwünscht, da der zur Verfügung stehende Platz insbesondere in der Raumfahrttechnik äußerst begrenzt ist.

### Vorteile der Erfindung

Durch die erfindungsgemäße Mehrlagen-Leiterplatte mit den kennzeichnenden Merkmalen des Anspruchs 1 werden die beim Stand der Technik auftretenden Nachteile vermieden. Besonders vorteilhaft ist, daß bei der erfindungsgemäßen Mehrlagen-Leiterplatte das wenigstens eine Kernsubstrat nur im Erstreckungsbereich des wenigstens einen Bauelementes vorgesehen ist und sich nicht über die gesamte laterale Ausdehnung der Leiterplatte erstreckt. Dadurch, daß das wenigstens eine Kernsubstrat nur an den Stellen vorgesehen ist, die später auf der Ober- oder Unterseite der Leiterplatte tatsächlich mit keramischen Bauelementen bestückt werden, ist das Gewicht der Leiterplatte im Vergleich zu den bekannten Mehrlagen-Leiterplatten mit einem sich über die gesamte Ausdehnung der Leiterplatte erstreckenden Kernsubstrat deutlich reduziert, was insbesondere in der Raumfahrttechnik einen wesentlichen Vorteil darstellt. Das wenigstens eine Kernsubstrat wird bei der Herstellung der Mehrlagen-Leiterplatte einfach als Einlegeteil in eine dafür vorgesehene Ausnehmung in einem inneren Lagenteil der Mehrlagen-Leiterplatte eingelegt. Auf das innere Lagenteil werden weitere mit Leiterbahnen versehene Isolierstofflagen aufgelegt. Der gesamte Stapel wird anschließend in bekannter Weise zu einer Mehrlagen-Leiterplatte weiterverarbeitet. Großflächige keramische Chipträger ohne Anschlußbeinchen werden nur an solchen Positionen auf der Außenseiten der Mehrlagen-Leiterplatte aufge-18tet, welche dem wenigstens einen im Inneren der Leiterplatte angeordneten Kernsubstrat gegenüberliegen. Dadurch ist gewährleistet, daß die Ausdehnungseigenschaften der Mehrlagen-Leiterplatte im Erstreckungsbereich der keramischen Chipträger an die Wärmeausdehnungseigenschaften dieser Bauelemente angepaßt sind, so daß eine Beschädigung der Lötstellen bei Temperaturwechselbelastungen vermieden wird.

Besonders vorteilhaft ist, wenn das innere Lagenteil mehrere durch Isolierstofflagen getrennten Leiterbahnebenen aufweist. Da das wenigstens einen Kernsubstrat in eine Ausnehmung den inneren Lagenteil angelegt ist, verbleibt noch genügend Raum in dem diese Ausnehmung umgehenden Rahmen, um dort weiteren Leiterbahnebenen vorzusehen. Dadurch kann die Größe der Mehrlagen-Leiterplatte weiter reduziert werden, da die Verdrahtung der Leiterbahnen zu mindestens Teilweise auch in dem inneren Lagenteil erfolgt, in der dass wenigsten eine Kernsubstrat angeordnet ist. Vorteilhaft ist weiterhin, dass durch Kontaktierungen, welche durch die Mehrlagen-Leiterplatte hindurch geführt werden sollen, nicht durch das Kernsubstrat geführt werden müssen, sonder einfach in dem Teil des inneren Lagenteil vorgesehen sind, welcher sich seitlich an das wenigstens eine Kernsubstrat anschließt. Hierdurch kann der technologische Aufwand bei der Herstellung der Durchkontaktierungen im Vergleich zum Stand der Technik deutlich verringert werden.

Vorteilhafte Ausbildungen und Weiterentwicklungen der Erfindung werden durch die in den unter Ansprüchen genannten Merkmalen ermöglicht. Vorteilhaft ist weiterhin, das Kernsubstrat als Einlegeteil möglichst formschlüssig in die dafür vorgesehene Ausnehmung in dem inneren Lagenteil einzubringen.

Vorteilhaft ist, wenn das innere Lagenteil mit dem wenigstens einen Kernsubstrat mittig zwischen den beiden Außenseiten der Mehrlagen-Leiterplatte angeordnet ist, so dass ein symmetrischer Lagenaufbau gegeben ist und die Wärmeausdehnungseigenschaften auf der Oberseite und der Unterseite der Leiterplatte gleichmäßig an das Ausdehnungsverhalten der keramischen Chipträger angepasst werden. Hierdurch wird vermieden, dass bei Temperaturwechselbelastungen unterschiedliche Scherkräfte an der Oberseite und der Unterseite des Kernsubstrat angreifen, was eine Verbiegung der Mehrlagen-Leiterplatte zur Folge hätte. Darüber hinaus läßt sich bei einer mittigen Anordnung des inneren Lagenteils insbesondere bei beidseitig bestückten Leiterplatten eine gleichmäßig gute thermomechanische Anpassung der Leiterplatte im Erstrekkungsbereich von auf der Oberseite und auf der Unterseite bestückten Bauelemente erreichen.

Besonders vorteilhaft ist weiterhin, wenn das Kernsubstrat aus Molybdän besteht. Molybdän bietet den Vorteil, einen niedrigen thermischen Ausdehnungskoeffizienten und gleichzeitig ein hohes Elastizitätsmodul zu besitzen. Durch die Kombination dieser beiden Eigenschaften wird einerseits eine Anpassung des Wärmeausdehnungsverhalten der Leiterplatte an den Ausdehnungskoeffizienten der keramischen Chipträger erreicht, andererseits ist der Molybdän-Kern aufgrund seiner Steifigkeit gut geeignet, um Scherspannungen entgegenzuwirken, welche in Folge des unterschiedlichen Ausdehnungsverhaltens von Leiterplattenmaterial und Kernsubstrat in der Mehrlagen-Leiterplatte auftreten.

Vorteilhaft ist weiterhin, die Verwendung eines Kohlefaser-Kerns, welcher aus mehreren schichtweise übereinander angeordneten unidirektionalen Kohlefaser-Gelegen besteht. Dieses Kernsubstrat weist vorteilhaft ein geringeres Gewicht auf als die aus Metall gefertigten Kerne. Dabei verbinden die in den Kohlefaser-Gelegen enthaltenen parallel verlaufenden Kohlefasern den Vorteil eines hohen Elastizitätsmoduls mit dem Vorteil eines geringen thermischen Ausdehnungskoeffizienten. Besonders vorteilhaft ist, wenn der Kohlefaser-Kern aus insgesamt vier unidirektionalen Kohlefaser-Gelegen gleicher Dicke besteht, die so angeordnet sind, daß die Kohlefasern in den beiden mittleren Gelegen parallel zueinander verlaufen und in den beiden äußeren Kohlefaser-Gelegen senkrecht zu den Kohlefasern in den beiden mittleren Kohlefaser-Gelegen orientiert sind. Diese Anordnung bewirkt vorteilhaft, daß an dem Kernsubstrat angreifende Scherkräfte keine Biegung oder Wölbung des Kerns verursachen und die Planarität des Kerns auch bei wechselnden Temperaturen erhalten bleibt.

Vorteilhaft ist weiterhin, daß auf den Außenseiten des Kernsubstrats eine vorzugsweise aus Kupfer bestehende Metallschicht aufgebracht ist. Besonders vorteilhaft ist, wenn die Metallschichten aus schwarzoxidierten Kupferschichten bestehen, da diese Schichten eine besonders hohe Haft- und Scherfestigkeit besitzen, so daß eine Rißbildung oder ein Ablösen des Kernsubstrats von den auf den Außenseiten des Kernsubstrats aufgebrachten Isolierstofflagen bei Temperaturwechselbelastungen vermieden wird.

### Zeichnung

Ausführungsbeispiele der Erfindung sind in der Zeichnung dargestellt und werden in der nachfolgenden Beschreibung näher erläutert. Es zeigt
Fig. 1 einen Querschnitt durch ein erstes Ausführungsbeispiel der Erfindung mit einem Molybdän-Kernsubstrat,
Fig. 2 ein zweites Ausführungsbeispiel eines vorteilhaften Aufbaus eines Kohlefaser-Kerns,
Fig. 3 schematisch eine Draufsicht auf eine Mehrlagen-Leiterplatte mit dem erfindungsgemäßen Kernsubstrat.

### Beschreibung der Ausführungsbeispiele

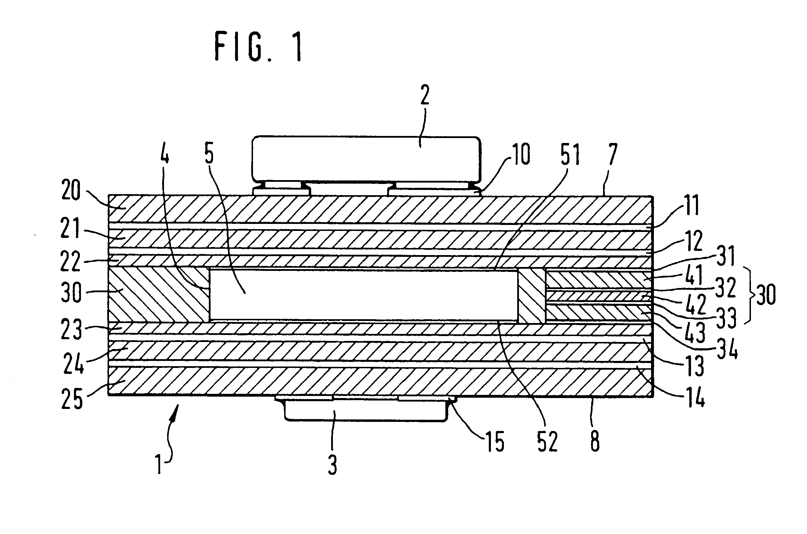

Fig. 1 zeigt schematisch einen Querschnitt durch ein erstes Ausführungsbeispiel einer erfindungsgemäßen Mehrlagen-Leiterplatte. Wie in Fig. 1 zu erkennen ist, weist die Mehrlagen-Leiterplatte 1 mehrere aus Epoxidharz bestehende Isolierstofflagen 20 bis 25 sowie Leiterbahnebenen 10 bis 15 auf, in denen die zur Verdrahtung der Bauelemente benötigten Leiterbahnen angeordnet sind. Die Leiterbahnen der verschiedenen Ebenen bestehen aus Kupfer und sind teilweise über nicht dargestellte Durchkontaktierungen, welche durch die Isolierstofflagen hindurchgeführt sind, in bekannter Weise miteinander verbunden. Auf der Oberseite 7 der Mehrlagen-Leiterplatte 1 ist ein keramischer Chipträger 2 ohne Anschlußbeinchen, ein sogenanntes LCCC-Bauelement (Leadless Ceramic Chip Carrier) auf Leiterbahnebene 10 direkt aufgelötet. Auf der Unterseite 8 der Mehrlagen-Leiterplatte 1 ist ein weiteres LCCC-Bauelement 3 auf Leiterbahnebene 15 aufgelötet, welches dem auf der Oberseite aufgelöteten Bauelement 2 in etwa gegenüberliegt. Die Wärmeableitung der von den Bauelementen 2,3 erzeugten Wärme kann über eine der inneren Kupferlagen 11,12 bzw. 13,14 erfolgen. Diese Kupferlagen können daher großflächige Kupferleiterbahnen aufweisen, um die Wärmeableitung zu verbessern. In der Mitte der Mehrlagen-Leiterplatte 1 ist ein inneres Lagenteil 30 mittig angeordnet, so daß der Abstand des inneren Lagenteils 30 von der Oberseite 7 in etwa gleich dem Abstand von der Unterseite 8 ist. Das Lagenteil 30 kann, wie im linken Bereich von Fig. 1 dargestellt, eine einzelne Isolierstofflage sein. Besonders vorteilhaft ist jedoch, wenn das Lagenteil 30, wie im rechten Bereich von Fig. 1 dargestellt, wiederum selbst ein Mehrlagen-Leiterplattenteil mit Isolierstofflagen 41,42,43 und weiteren Leiterbahnebenen 31,32,33,34 ist.

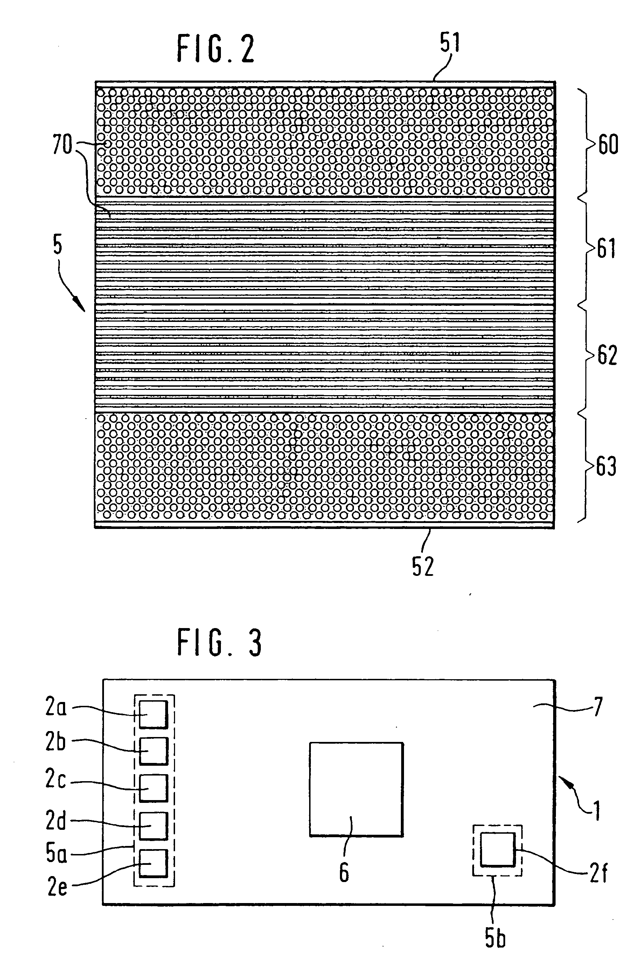

Das innere Lagenteil 30 weist weiterhin ein Kernsubstrat 5 auf, welches als Einlegeteil in eine dafür vorgesehene Ausnehmung 4 des Lagenteils 30 möglichst formschlüssig eingebracht ist. In dem hier gezeigten Ausführungsbeispiel besteht das Kernsubstrat 5 aus Molybdän. Der Molybdän-Kern 5 ist allseitig mit einer galvanisch aufgebrachten, schwarzoxidierten Kupferschicht versehen, von der in Fig. 1 die den Isolierstofflagen 22 und 23 zugewandten schwarzoxidierten Kupferflächen 51 und 52 zu erkennen sind. Durch die schwarzoxidierte Kupferschicht 51,52 wird die Haftfestigkeit und Scherfestigkeit insbesondere an der Verbindungsfläche zwischen Kernsubstrat und Isolierstofflagen 22 und 23 vergrößert. Wie in Fig. 1 dargestellt, ist die laterale Ausdehnung des Kernsubstrat 5 in etwa auf den Erstreckungsbereich des Bauelementes 2 auf der Oberseite 7 bzw. den Erstreckungsbereich des Bauelementes 3 auf der Unterseite 8 beschränkt. Die laterale Ausdehnung des Kernsubstrats 5 kann dabei, wie in Fig. 1 zu erkennen ist, etwas über diesen Erstreckungsbereich hinaus ausgedehnt sein. Insbesondere ist es auch möglich, daß die laterale Ausdehnung des Kernsubstrats, wie in Fig. 3 gezeigt, auf den Erstreckungsbereich mehrerer benachbarter Bauelemente 2a bis 2e ausgedehnt ist. Die gestrichelten Linien in Fig. 3, welche eine Draufsicht auf ein weiteres Ausführungsbeispiel einer erfindungsgemäßen Mehrlagen-Leiterplatte zeigt, markieren die Position eines Kernsubstrats 5a und eines Kernsubstrats 5b, welche beide in einer Ebene unterhalb der Oberseite 7 der Leiterplatte 1 angeordnet ist. Die benachbarten Bauelemente 2a bis 2e sind in diesem Ausführungsbeispiel oberhalb des Kernsubstrats 5a aufgebracht. Ein weiteres keramisches Chipträger-Bauelememt 2f ist über dem zweiten Kernsubstrat 5b aufgebracht, das in dem gleichen inneren Lagenteil 30 in einer zweiten Ausnehmung angeordnet ist. Außerdem sind noch weitere Bauelemente 6 vorgesehen, welche zur Aufnahme von Scherspannungen mit elastisch verformbaren Anschlußbeinchen versehen sind und welche daher nicht ober- oder unterhalb eines Kernsubstrats auf der Leiterplatte 1 bestückt werden brauchen. Durch die Kernsubstrate wird vorteilhaft erreicht, daß in dem mit den Kernsubstraten versehenen Bereich der hohe Temperaturausdehnungskoeffizient des Leiterplattenmaterials von ca. 15 ppm/K in lateraler Richtung durch den relativ kleinen Temperaturausdehnungskoeffizienten des Molybdän-Kerns von etwa 5,3 ppm/K auf einen effektiven Ausdehnungskoeffizieneten von 6,5 bis 7,5 ppm/K reduziert wird, so daß das Wärmeausdehungsverhalten der Mehrlagen-Leiterplatte 1 im Erstreckungsbereich der keramischen Chipträger-Bauelemente gut an das Wärmeausdehungsverhalten dieser Bauelemente angepaßt ist. Wie insbesondere in Fig. 3 gut zu erkennen ist, beanspruchen die Kernsubstrate 5a und 5b dabei nur einen kleinen Teil des inneren Lagenteils 30, so daß noch genügend Platz vorhanden ist um weitere Leiterbahnebenen und damit einen Teil der Leiterbahnverdrahtung in dem inneren Lagenteil 30 vorzusehen. Insbesondere wird hierdurch die Herstellung von durch die Leiterplatte hindurchgeführten Durchkontaktierungen erleichtert, da diese nicht durch den metallischen Molybdän-Kern hindurchgeführt werden müssen, was aufwendige Herstellungstechniken erforderlich machen würde.

Bei der Herstellung der Mehrlagen-Leiterplatte 1 wird folgendermaßen verfahren. Zunächst wird in bekannter Weise das innere Lagenteil 30 durch Stapeln zweier doppelseitig kupferkaschierter Epoxidharz-Laminate 41 und 43 hergestellt, welche durch eine zwischengelagerte, ebenfalls aus Epoxidharz bestehende Prepreg-Schicht 42 miteinander unter Vakuum verpreßt und ausgehärtet werden. Die Herstellung von Leiterbahnen in den Kupferlagen 31,32,33 und 34 kann in bekannter Weise durch Beschichten der einzelnen Laminate mit Fotolack und anschließendes Ätzen erfolgen. Die Leiterbahnebenen 31 bis 34 erstrecken sich nicht durch das ganze innere Lagenteil 30. An einer nicht mit Leiterbahnen versehenen Stelle des inneren Lagenteils 30 wird eine durchgehende Ausnehmung 4 aus dem Lagenteil ausgefräst. In die Ausnehmung 4 wird anschließend ein Kernsubstrat 5 eingelegt. Das Kernsubstrat 5 ist in dem hier gezeigten Ausführungsbeispiel ein Molybdän-Kern mit einem rechteckigen Querschnitt, der allseitig mit einer galvanisch aufgebrachten schwarzoxidierten Kupferschicht 51,52 versehen ist. Die Ausnehmung 4 ist mit einer gewissen Toleranz gefertigt, so daß der Molybdän-Kern ohne Kraftaufwand in die Ausnehmung 4 des innneren Lagenteils 30 eingelegt werden kann. Das innere Lagenteil 30 wird mit weiteren Epoxidharz-Laminaten 20 bis 25 und Klebefolien in einem Stapel angeordnet. Die Epoxidharz-Laminate 20 bis 25 sind bereits mit Leiterbahnen in den Lagen 10 bis 15 versehen, welche in bekannter Weise durch Fotodruck und anschließendes Ätzen und Schwarzoxidieren der Kupferlagen hergestellt sind. Danach wird der gesamte Stapel im Vakuum verpreßt. Beim Verpressen dringt flüssig gewordenes Epoxidharz der Prepregfolien in die Ritzen zwischem dem Kernsubstrat 5 und der Ausnehmung 4 ein, so daß eine formschlüssige Verbindung entsteht. Anschließend werden in bekannter Weise Durchkontaktierungen in der Mehrlagen-Leiterplatte durch Bohren der Leiterplatte und Metallisieren der Innenwandungen der Bohrungslöcher hergestellt.

Bei einem weiteren Ausführungsbeispiel der Erfindung ist vorgesehen, das in Fig. 1 gezeigte Kernsubtrat 5 als Kohlefaser-Kern auszugestalten. Ansonsten wird der in Fig. 1 gezeigte Lagenaufbau beibehalten. Der Aufbau des Kohlefaser-Kerns ist in Fig. 2 dargestellt. Der Kohlefaser-Kern besteht aus unidirektionalen Kohlefaser-Gelegen, sogenannten UD-Gelegen, die jeweils eine Vielzahl von parallel angeordneten, etwa 5 µm dicken Kohlefasern aufweisen, welche in Epoxidharz eingebettet sind und 100 - 125 µm dicke teilgehärtete Prepregs bilden. Diese Prepregs werden in einer Presse unter Druck- und Wärmeeinwirkung im Vakuum zum Kohlefaser-Kern verpreßt. Beim Verpressen werden gleichzeitig Kupferfolien auf die Außenlagen auflaminiert. Besondere Vorteile weist dabei der in Fig. 2 dargestellte spezielle Lagenaufbau des Kerns auf. Der Kern besteht aus vier unidirektionalen Gelegen 60,61,62 und 63. Die Kohlefasern 70 in den mittleren beiden Gelegen 61 und 62 sind gleichgerichtet und verlaufen parallel zueinander, während die Kohlefasern 70 in den äußeren Gelegen 60 und 63 um 90° versetzt zu den Kohlefasern in den mittleren Gelegen orientiert sind. Die äußeren Kohlefaser-Gelege 60 und 63 sind mit den Kupferschichten 51 und 52 versehen. Der hier dargestellt Aufbau des Kohlefaser-Kerns hat den Vorteil, daß sich der Kern nach dem Verpressen weder wölbt noch verwindet, sondern seine Planarität beibehält, was darauf zurückzuführen ist, daß die mechanischen Spannungen an den beiden Außenseiten des Kerns gleich groß sind.

## Patentansprüche

1. Mehrlagen-Leiterplatte (1) mit mehreren übereinander angeordneten, durch Isolierstofflagen (20, 21, 22, 23, 24, 25) getrennten Leiterbahnebenen (10, 11, 12, 13, 14) sowie wenigsten einem auf einer der beiden Außenseiten (7, 8) der Mehrlagen-Leiterplatte bestückten elektronischen Bauelement (2, 3), insbesondere einem LCCC-Bauelement, und mit wenigstens einem in der Mehrlagen-Leiterplatte zwischen den äußeren Isolierstofflagen angeordneten Kernsubstrat (5), welches die Wärmeausdehnungseigenschaften der Mehrlagen-Leiterplatte zumindest im Erstreckungsbereich des wenigstes einen Bauelementes an die Wärmeausdehnungseigenschaften des Bauelementes weitgehend anpasst, wobei zwischen den beiden äußeren Isolierstofflagen (20, 25) der Mehrlagen-Leiterplatte (1) eine mit einer Ausnehmung (4) versehenen inneres Lagenteil (30) vorgesehen ist, wobei die laterale Ausdehnung der Ausnehmung in dem inneren Lagenteil (30) in etwa auf den Erstreckungsbereich des wenigstens einen Bauelementes (2, 3) beschränkt ist und in die Ausnehmung (4) das wenigstens eine Kernsubstrat (5) eingebracht ist, **dadurch gekennzeichnet, dass** das innere Lagenteil (30) mehrere durch Isolierstofflapen (41, 42, 43) getrennte Leiterbahnebenen (31, 32, 33, 34) aufweist.

2. Mehrlagenleiterplatte nach Anspruch 1,
**dadurch gekennzeichnet,**
**dass** das Kensubstrat (5) möglichst formschlüssig in die Ausnehmung (4) des inneren Lagenteils (30) eingebraucht ist.

3. Mehrlagenleiterplatte nach Anspruch 1,
**dadurch gekennzeichnet,**
**dass** das innere Lagenteil (30) mittig zwischen den beiden Außenseiten (7, 8) der Mehrlagen-Leiterplatte (1) angeordnet ist.

4. Mehrlagenleiterplatte nach einem der Ansprüche 1 bis 3,
**dadurch gekennzeichnet,**
**dass** als Kensubstrat (5) ein Molybdän-Kern vorgesehen ist.

5. Mehrlagenleiterplatte nach einem der Ansprüche 1 bis 3,
**dadurch gekennzeichnet,**
**dass** als Kernsubstrat (5) Kohlenfasserkern vorgesehen ist, welcher aus mehreren schichtweise übereinander angeordnet unidirektionalen Kohlenfaser-Gelegen (60, 61, 62, 63) besteht.

6. Mehrlagenleiterplatte nach Anspruch 5,
**dadurch gekennzeichnet,**
**dass** der Kohlenfaser-Kern aus insgesamt vier unidirektionalen Kohlenfaser-Gelegen (60, 61, 62, 63) gleicher Dicke besteht die so angeordnet sind, dass die Kohlefasern (70) in den beiden mittleren Kohlenfaser-Gelegen (60, 61, 62, 63) parallel zueinander verlaufen und die Kohlenfasern (70) in den beiden äußeren Kohlenfaser-Gelegen (60, 61, 62, 63) um 90° versetzt zu den Kohlefasern in den beiden mittleren Kohlenfaser-Gelegen (61, 62) verlaufen.

7. Mehrlagenleiterplatte nach einem der Ansprüche 4 bis 6,
**dadurch gekennzeichnet,**
**dass** wenigstens auf den Außenseiten des Kernsubstrats (5), welche über den inneren Lagenteil (30) angeordneten Isolierstofflagen (22, 23) zugewandt sind, eine Metallschicht (51, 52) aufgebraucht ist.

8. Mehrlagenleiterplatte nach Anspruch 7,
**dadurch gekennzeichnet,**
**dass** die Metallschichten (51, 52) aus Kupfer bestehen.

9. Mehrlagenleiterplatte nach Anspruch 8,
**dadurch gekennzeichnet,**
**dass** die Kupferschichten (51, 52) schwarzoxidierte Kupferschichten sind

## Claims

1. A multilayer printed circuit board (1) with a plurality of conductor path planes (10, 11, 12, 13, 14) separated by insulating material layers (20, 21, 22, 23, 24, 25) arranged one above the other and at least one electronic component (2, 3), in particular a LCCC component, assembled on one of the two outer faces (7, 8) of the multilayer printed circuit board, and with at least one core substrate (5) arranged in the multilayer printed circuit board between the outer insulating material layers, which substantially adapts the thermal expansion properties of the multilayer printed circuit board to the thermal expansion properties of the component, at least in the region of extension of the at least one component, an inner layer portion (30) having a cavity (4) being provided between the two outer insulating material layers (20, 25) of the multilayer printed circuit board (1), the lateral extension of the cavity in the inner layer portion (30) being confined approximately to the region of extension of the at least one component (2, 3) and the at least one core substrate (5) being introduced into the cavity (4), **characterised in that** the inner layer portion (30) comprises a plurality of conductor path planes (31, 32, 33, 34) separated by insulating material layers (41, 42, 43).

2. The multilayer printed circuit board according to claim 1, **characterised in that** the core substrate (5) is inserted into the cavity (4) of the inner layer portion (30) in a manner which is as snug as possible.

3. The multilayer printed circuit board according to claim 1, **characterised in that** the inner layer portion (30) is arranged centrally between the two outer faces (7, 8) of the multilayer printed circuit board (1).

4. The multilayer printed circuit board according to one of claims 1 to 3, **characterised in that** a molybdenum core is provided as a core substrate (5).

5. The multilayer printed circuit board according to one of claims 1 to 3, **characterised in that** a carbon fibre core is provided as a core substrate (5) which consists of a plurality of unidirectional carbon fibre plies (60, 61, 62, 63) arranged one above the other in layers.

6. The multilayer printed circuit board according to claim 5, **characterised in that** the carbon fibre core consists of a total of four unidirectional carbon fibre plies (60, 61, 62, 63) of the same thickness, which are arranged such that the carbon fibres .(70) extend parallel to one another in the two central carbon fibre plies (60, 61, 62, 63) and the carbon fibres (70) in the two outer carbon fibres plies (60, 61, 62, 63) extend offset by 90° to the carbon fibres in the two central carbon fibre plies (61, 62).

7. The multilayer printed circuit board according to one of claims 4 to 6, **characterised in that** a metal coating (51, 52) is applied at least to the outer faces of the core substrate (5) which face insulating material layers (22, 23) arranged over the inner layer portion (30).

8. The multilayer printed circuit board according to claim 7, **characterised in that** the metal coatings (51, 52) consist of copper.

9. The multilayer printed circuit board according to claim 8, **characterised in that** the copper layers (51, 52) are black-oxidized copper layers.

## Revendications

1. Carte de circuits imprimés multicouche (1) comportant plusieurs niveaux de pistes conductrices (10, 11, 12, 13, 14) superposés, séparés par des couches de matériau isolant (20, 21, 22, 23, 24, 25) ainsi qu'au moins un composant électronique (2, 3), notamment un composant LCCC, monté sur l'une de deux faces extérieures (7, 8) de la carte de circuits imprimés multicouche, et au moins un substrat noyau (5) disposé entre les couches de matériau isolant extérieures dans la carte de circuits imprimés multicouche et destiné à adapter en grande partie les propriétés de dilation thermique de la carte de circuits imprimés multicouche au moins dans la zone d'étendue du au moins un composant aux propriétés de dilation thermique du composant, un élément de couche interne (30) muni d'un évidement (4) étant prévu entre les deux couches de matériau isolant extérieures (20, 25) de la carte de circuits imprimés multicouche (1), la dimension latérale de l'évidement dans l'élément de couche interne (30) étant approximativement limitée à la zone d'étendue du au moins un composant (2, 3) et le au moins un substrat noyau (5) étant incorporé à l'évidement (4), **caractérisée en ce que** l'élément de couche interne (30) présente plusieurs niveaux de pistes conductrices (31, 32, 33, 34) séparés par des couches de matériau isolant (41, 42, 43).

2. Carte de circuits imprimés multicouche selon la revendication 1, **caractérisée en ce que** le substrat noyau (5) est incorporé à l'évidement (4) de l'élément de couche interne (30) par liaison de forme.

3. Carte de circuits imprimés multicouche selon la revendication 1, **caractérisée en ce que** l'élément de couche interne (30) est placé de manière centrée entre les deux faces extérieures (7, 8) de la carte à circuits imprimés multicouche (1).

4. Carte de circuits imprimés multicouche selon l'une des revendications 1 à 3, **caractérisé en ce que** le substrat noyau (5) est un noyau en molybdène.

5. Carte de circuits imprimés multicouche selon l'une des revendications 1 à 3, **caractérisée en ce qu'**un noyau en fibres de carbone composé de plusieurs nappes de fibres de carbone (60, 61, 62, 63) unidirectionnelles disposées en couches superposées est prévu comme substrat noyau (5).

6. Carte de circuits imprimés multicouche selon la revendication 5, **caractérisée en ce que** le noyau de fibre de carbone se compose au total de quatre nappes de fibres de carbone (60, 61, 62, 63) unidirectionnelles d'épaisseur égale, disposées de manière que, dans les deux nappes de fibre de carbone centrales (60, 61, 62, 63), les fibres de carbone (70) sont placées parallèlement les unes aux autres et que, dans les deux nappes de fibre de carbone extérieures (60, 61, 62, 63), les fibres de carbone (70) sont décalées de 90° par rapport aux fibres de carbones dans les deux nappes de fibres de carbone centrales (61, 62).

7. Carte de circuits imprimés multicouche selon l'une des revendications 1 à 3, **caractérisé en ce qu'**une couche métallique (51, 52) est appliquée¹ au moins sur les faces extérieures du substrat noyau (5) tournées vers les couches de matériau isolant (22, 23) disposées au-dessus de l'élément de couche interne (30).²
¹ Im Deutschen steht : « aufgebraucht ». Wahrscheinlich ein Tippfehler, deshalb mit « aufgebracht » übersetzt.
² Satz im Deutschen unklar.

8. Carte de circuits imprimés multicouche selon la revendication 7, **caractérisée en ce que** les couches métalliques (51, 52) sont en cuivre.

9. Carte de circuits imprimés multicouche selon la revendication 8, **caractérisée en ce que** les couches de cuivre (51, 52) sont des couches cuivre oxydé noir.
